(19) Europäisches Patentamt
European Patent Office
Office européen des brevets

(11) **EP 1 787 785 B1**

(12) **EUROPEAN PATENT SPECIFICATION**

(45) Date of publication and mention
of the grant of the patent:
**23.05.2012 Bulletin 2012/21**

(51) Int Cl.:
*H01L 31/18* (2006.01)    *B29C 47/02* (2006.01)
*B29C 47/12* (2006.01)    *B29C 47/06* (2006.01)
*B81C 1/00* (2006.01)

(21) Application number: **06123904.2**

(22) Date of filing: **13.11.2006**

(54) **Extrusion system for producing fine structures having high aspect ratio**

Extrusionswerkzeug zur Herstellung feiner Strukturen mit großem Aspektverhältnis

Moule d'extrusion pour la réalisation de structures fines ayant un rapport de forme élevé

(84) Designated Contracting States:
**DE FR GB**

(30) Priority: **17.11.2005 US 282882**

(43) Date of publication of application:
**23.05.2007 Bulletin 2007/21**

(73) Proprietor: **SolarWorld Innovations GmbH**
**09599 Freiberg/Sachsen (DE)**

(72) Inventors:
• **Fork, David K.**
**Los Altos 94024 (US)**
• **Hantschel, Thomas**
**B-8560 Moorsele (BE)**

(74) Representative: **Skone James, Robert Edmund**
**Gill Jennings & Every LLP**
**The Broadgate Tower**
**20 Primrose Street**
**London EC2A 2ES (GB)**

(56) References cited:
EP-A- 1 787 786       WO-A-00/50215
WO-A-91/15355         WO-A-03/076701
JP-A- 2005 051 216    US-A1- 2003 201 581

• **HOY VAN C ET AL: "MICROFABRICATION OF CERAMICS BY CO-EXTRUSION" JOURNAL OF THE AMERICAN CERAMIC SOCIETY, BLACKWELL PUBLISHING, MALDEN, MA, US, vol. 81, no. 1, 1 January 1998 (1998-01-01), pages 152-158, XP000728571 ISSN: 0002-7820**

**Description**

The following relates to micro-extrusion systems and methods for coextruding multiple similar and/or dissimilar materials to form relatively fine structures with relatively high aspect ratios.

Conventional techniques cannot render relatively high aspect-ratio (e.g., 10:1) fine featured (e.g., less then 5 micron) porous (e.g., 0.01 mm RMS) structures for costs below $1/sq. ft. Thus, extrusion typically is not used for creating conducting contacts and/or channels for electrochemical (e.g., fuel), solar, and/or other types of cells, which leverage high aspect-ratio fine featured porous structures to increase efficiency and electrical power generation.

A number of extrusion systems are known. For example, WO-A-00/50215 describes an extrusion apparatus including a housing having a cavity and a removable shim having a plurality of slits therethrough forming a corresponding plurality of flow channels. The slits of the shim are divergently flared at the outlets of the flow channels to facilitate widening of the individual streams of extrudable fluid flowing through.

JP-A-200505126 describes a droplet dispenser having two or more lines of nozzles, the outlets of which vary in diameter.

WO-A-91/15355 describes apparatus for forming an inelastic multicomponent film having an elastomeric core and a surrounding inelastic matrix prepared by coextrusion.

A further extrusion device is described in US-A-2003/0201581.

In accordance with the present invention, a device for extruding/dispensing materials on a substrate, the device including an applicator comprises:

a housing;
at least three channels enclosed by the housing, the at least three channels facilitating flow of materials;
at least one entrance port associated with each of the channels for feeding a material into each channel; and
an exit port for co-extruding/dispensing the materials and is characterized in that the at least three channels are arranged to define:

a central channel extending between a first end and a second end, the first end of the central channel communicating with the corresponding entrance port of said channel, and
first and second side channels disposed on laterally opposite sides of the central channel, each of the first and second side channels extending between an associated first end and an associated second end, wherein the first ends of the first and second side channels respectively communicate with corresponding entrance ports of said channels, and in that the housing further comprises:

a single volume region communicating with the second ends of each of the central channel and the first and second side channels, the single volume region also communicating with the exit port, wherein the first and second side channels and the central channel converge at the single volume region such that when a first material is introduced into the central channel through the first inlet port and a second material is introduced into the first and second side channels through the second and third inlet ports, the first material and second material form a single flow in the single volume region in which the first material is sandwiched laterally between portions of the second material, the structure of the device being such that as the first and second materials are co-extruded onto a substrate, the first and second materials will form parallel elongated gridline structures on the surface of the substrate, each said gridline structure including a central line structure formed by said first material that contacts the surface of the substrate, and support structures formed by the second material that contacts opposing side surfaces of the central line structure, wherein the central channel is formed such that said central line structure of said gridline structure will have an aspect ratio greater than 2:1, and wherein the central channel has a width not greater than 100 microns.

The device can co-extrude the materials on a substrate to generate a relatively fine feature with a relatively high aspect ratio.

BRIEF DESCRIPTION OF THE DRAWINGS

FIGURE 1 illustrates an extrusion device with an applicator for concurrently applying one or more materials on a substrate;

FIGURE 2 illustrates a comparative example of an applicator;

FIGURE 3 illustrates another comparative example of an applicator;

FIGURE 4 illustrates a plurality of dispensing ports;

FIGURE 5 illustrates another comparative example of an applicator;

FIGURE 6 illustrates an exemplary portion of a photovoltaic cell;

FIGURE 7 illustrates a method for fabricating the photovoltaic cell;

FIGURE 8 illustrates a method for fabricating grid lines;

FIGURE 9 illustrates an exploded view of a portion of an exemplary applicator;

FIGURE 10 illustrates a cross section of gridlines;

FIGURE 11 illustrates a portion of an exemplary fuel cell;

FIGURE 12 illustrates a method for fabricating the electrode of the fuel cell described in FIGURE 11;

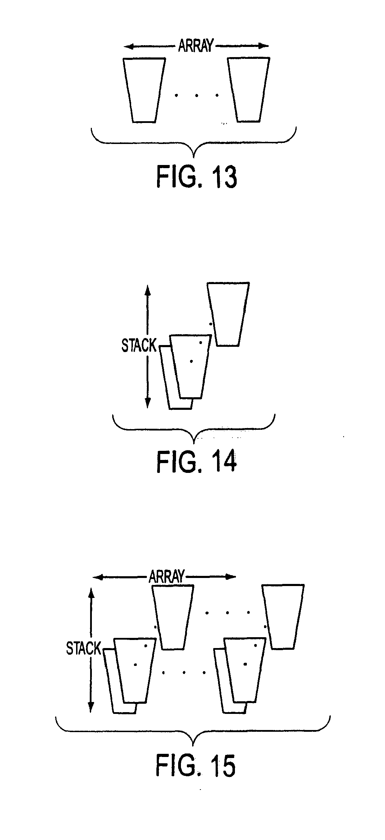

FIGURE 13 illustrates a serial array of applicators;

FIGURE 14 illustrates stacked applicators; and

FIGURE 15 illustrates a matrix of applicators.

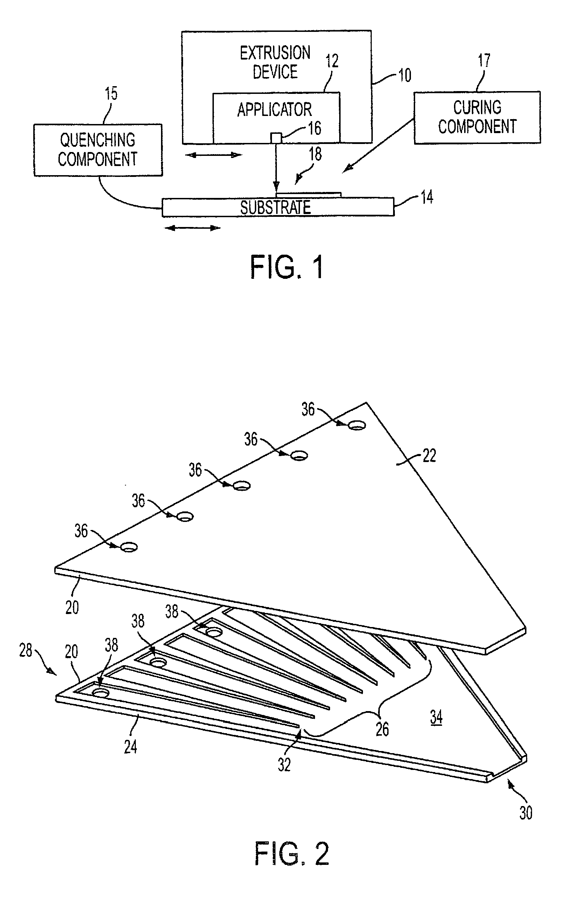

FIGURE 1 illustrates extrusion device 10 with applicator 12 for concurrently applying two or more substantially similar and/or different materials (e.g., fluids, pastes, liquids, inks, etc.) on substrate 14. Materials are applied through pushing and/or drawing techniques (e.g., hot and cold) in which materials are pushed (e.g., squeezed, etc.) and/or drawn (e.g., via a vacuum, etc.) through applicator 12 and out one or more dispensing openings 16 of applicator 12. Materials are dispensed to create one or more variously shaped entities (e.g., continuous, multi-sectional, rectangular, triangular, irregular, etc.) on substrate 14. Suitable entities include, but are not limited to, a bead, point, track, pipe, frame, rail, rod, seal, volume within a void, etc. Shape of the entity can be defined through at least one of shapes of the one or more dispensing openings 16, structure within applicator 12 (e.g., channels), characteristics of materials (e.g., viscosity, etc.), and extrusion technique (e.g., flow rate, pressure, temperature, etc.). Suitable materials include, but are not limited to, silver, copper, aluminum, steel, plastic, ceramic, oil, etc., combinations thereof, and/or variations thereof, including combining the above with other substances to obtain a desired density, viscosity, texture, color.

Multiple materials (e.g., with viscosity from about 1 centipoise (cP) to about several hundred thousand cP) can be pushed and/or pulled through applicator 12 and dispensed together to produce one or more structured layers of materials on substrate 14. Multiple materials can be pushed and/or pulled through applicator 12 under laminar flow to mitigate mixing of the materials. Mixing can be further reduced by using substantially immiscible materials, including mixing a material with one or more other materials, impurities, dopants, coatings, etc. to create pastes, etc. Materials can be prepared such that they are mutually insoluble, enabling striped layers to be extruded onto substrate 14 through applicator 12 with relatively little mixing. Viscosities of materials can also be matched to reduce shear and mixing between flows.

Applicator 12 can be a nozzle, die, or any structure that receives materials and facilitates applying the materials to substrate 14. Applicator 12 can be micromachined with structures that receive and converge individual materials. Applicator 12 can include N channels, where N is an integer equal to or greater than one (e.g., thousands), for merging materials within applicator 12 into a single flow dispensed by applicator 12. Each N channel can be used for introducing a different material and/or multiple channels can be used for introducing a substantially similar material. Where applicator 12 includes a single channel, the different material can be introduced through similar and/or different ports into the channel.

Each channel can extend through a length (e.g., the entire length or a subset thereof) of applicator 12. For instance, one or more of the N channels can be designed to be shorter than the length of applicator 12, but relatively longer than an entrance length to produce laminar flow, wherein flow velocity is stabilized prior to merging materials. This can be achieved through known micro-machining techniques such as deep reactive ion etching, wafer bonding, etc. Creating applicator 12 for laminar flow mitigates and/or minimizes mixing of materials as materials traverse through applicator 12 and out of its opening. N channels may also be shaped to counteract effects of surface tension on materials as they progress from applicator 12 to substrate 14. Each channel may be uniquely and/or similarly shaped, including uniform and/or non-uniform shapes.

To deposit the entity (e.g., bead, point, etc.) onto substrate 14, applicator 12 is suitably positioned with respect to substrate 14, and the one or more materials are dispensed through applicator 12. Such positioning can be based on factors such as distance between applicator 12 and substrate 14, the angle of the dispensing end of applicator 12 with respect to substrate 14 (e.g., from parallel to perpendicular to substrate 14) to increase transfer efficiency, entity definition (e.g., width, height, length, diameter, etc), entity characteristics (e.g., strength, pliability, etc.), etc. Such positioning may result in contact between applicator 12 and substrate 14. FIGURE 1 depicts applicator 12 positioned above substrate 14 during dispensing.

Prior to, during, and/or after dispensing the materials on substrate 14, device 10 and applicator 12 and/or substrate 14 can be moved. For example, to create a point (or dot, ball, etc.) at a particular location on substrate 14, device 10 and applicator 12 and/or substrate 14 can be moved and suitably positioned. Subsequently, materials can be dispensed to create the point. Thereafter, device 10 and applicator 12 and/or substrate 14 can be moved to another position for a subsequent application, if any. In another example, to create a bead, device 10 and applicator 12 and/or substrate 14 can be moved to an initial position. During dispensing of materials on substrate 14, device 10 and applicator 12 and/or substrate 14 can be moved in a direction to facilitate forming the bead on substrate 14. FIGURE 1 depicts applicator 12 dispensing a flow of materials to form a continuous bead on substrate 14 as depicted at 18.

To limit the tendency for materials to intermix after extrusion, the bead of material leaving applicator 12 can be quenched on substrate 14 by making substrate 14 relatively cold with respect to applicator 12, e.g., quenching component 15 can be used to cool substrate 14. In another technique, materials can be cured by thermal, optical and/or other means upon exit from applicator 12, e.g., curing component 17 can thermally and/or optically cure materials. If one or both materials includes ultraviolet curing agent, material can be bound up into solid form to enable further processing without mixing.

Applicator 12 can be manufactured a variety of ways, (i) via deep silicon reactive ion etching and wafer bonding; (ii) electroplating metal up through features in a patterned resist structure; (iii) brazing together layers of etched sheet metal; (iv) generating structures out of photo-definable polymer such as SUB; (v) being machined or molded out of metal and/or plastic using conventional manufacturing techniques.

Relative speed of motion between applicator 12 and substrate 14 and speed at which materials are dispensed determine characteristics such as whether material is stretched or compressed as it is placed on substrate 14. Rates also determine thickness and/or average thickness of extruded material. Typically, these rates are set based at least in part on one or more of application, materials, and/or substrate 14. Rates may be set to minimize separation between adjacent materials and/or deviations from desired dimensions. Airflow may be used to direct one or more materials onto substrate 14. Airflow around dispensing opening of applicator 12 can be provided to pull materials in desired directions. If substrate is porous, as in the case of some fuel cell electrodes, airflow (e.g., a vacuum) can be pulled through substrate 14 to increase attachment of material to substrate 14. Flow can also be controlled through controlling pressure, temperature, etc. of applicator 12 and/or substrate 14 to achieve desired flow properties of material being extruded.

The duty cycle of each dispensed material can be controlled by adjusting a corresponding pressure of each material entering applicator 12 in which each pressure can be similar and/or different. Additionally and/or alternatively, the duty cycle can be determined by design of applicator 12. For instance, pitch of each dispensed material can be defined by geometry of applicator 12 (e.g., width of opening, number of channels, shape of channels, etc.). Both pitch and duty cycle can be configured for a particular design. In one application widths of dispensed materials may be substantially similar. With another application, width of one or more of materials may be different. In another application, one or more groups of channels may have different widths wherein channels within anyone group may have substantial similar widths. Because surface tension forces may distort pitch of material (e.g., at edges), pitch of each channel can be adjusted to compensate.

One or more materials can be pre-filled within one or more storage elements (not shown) associated with device 10, *e.g.,* materials may be stored together in a similar storage element and/or separated into individual storage elements, Additionally and/or alternatively, materials may be supplied to device 10 before and/or during extrusion via one or more optional input ports (not shown) of device 10.

Device 10 may include more than one applicator 12. Suitable configurations include, but are not limited to, a serial array of applicators 12 (e.g., staggered, adjacent, etc.), to increase a width of a single pass; stacked applicators 12, to apply multiple layers in a single pass; a matrix of applicators (serial array / stacked combination) to concurrently increase the width and the number of layers, to increase efficiency, etc. Such configurations are depicted in FIGURES 18, 19, and 20.

Each applicator 12 may be used to dispense a plurality of materials. Substantially all of applicators 12 could dispense similar materials. Materials dispensed by one applicators 12 may be different from materials dispensed by one or more other applicators 12. Each of applicators 12 could dispense different materials, wherein materials dispensed by any one applicator 12 may be similar and/or different. Each of applicators 12 may only dispense a single material.

Applicators 12 can be configured such that device 10 dispenses materials in an interleaved and/or adjacent manner. Thus, first applicator 12 dispensing K materials (where K is an integer equal to or greater than two) may dispense K adjacent materials, K materials with gaps in between, and/or some combination thereof. Second applicator 12 dispensing L materials (where L is an integer equal to or greater than two) may dispense L adjacent materials next to the K adjacent materials, L materials within the gaps between the K materials, and/or some combination thereof. Third, fourth, etc. applicator 12 can be similarly used to apply materials in connection with K and L materials.

Device 10 can be used to create solar and/or electrochemical (e.g., fuel, battery, etc.) cell electrodes. Device 10 can be used to extrude lines of silver paste into high aspect ratio grid lines surrounded by sacrificial material that is in place only as long as needed to maintain the shape of the electrode on a solar cell substrate before or during any processing. Sacrificial material leads to an overall larger output orifice, and hence a lower pressure drop for a given material flow speed. Higher process speed is therefore achievable. When convergent flow is used a minimum fabrication feature of device 10 is larger than the minimum feature of an extruded gridline.

In addition to striped materials with a lateral variation, variations of applicator 12 can be used to additionally and/or alternatively introduce materials with vertical variation, e.g., for introducing barrier layers onto substrate 14. Vertical variation can be implemented by forming channels that converge dissimilar materials together in the vertical direction within the manifold, With a solar cell application, it may be advantageous to introduce a metal bi-layer onto the cell surface with one metal making contact to the silicon as a diffusion barrier, and a second metal on top selected for either lower cost or higher conductance.

Device 10 can be used to facilitate manufacturing light control films such as those used for computer privacy screens. Typically, such screens have a series of tall, thin opaque louver layers in a clear matrix to limit the optical transmission to a narrow range of angles. Applicator 12 could dispense alternating layers of opaque and clear materials to form a layer of louvers by molding a ridge pattern into plastic and pressing a black matrix in between the ridges, wherein the two structures can be laminated together. Device 10 can be used to print striated structures with a high aspect ratio such as artificial muscle. For instance, lateral co-extrusion in combination with a valving scheme could be used to make such structures. Multiple bands of muscle like material could be laid out in varied directions to produce a variety of actuations.

Device 10 and applicator 12 can be used for printing. By utilizing multi-pass printing, with or without registration, systems could be developed to create thicker layers, or layers with a wider mix of materials, or functional composite materials with novel properties. Process direction can also be changed from layer to layer in order to create unique structures. For example, device 10 and applicator 12 could be used to create high strength plastics with crisscrossing grain structures similar to plywood. Device 10 and applicator 12 enables printing a wide range of materials with viscosities up to the order several hundred thousand cP, with high aspect ratios on the order of 10:1 and features as small as 100 nanometers.

Employing applicator 12 can reduce costs. Typical costs associated with fabricating electrodes of a fuel cell can be reduced $10 to $20 per square foot of electrode area. A wide array of materials ranging from paints, waxes, colloidal suspensions, pastes, resists, particle suspensions, gels, thixotropic materials, etc. can be extruded through applicator 12. Materials are not limited by viscosity and/or by need to form a vapor, and more than one material can be dispensed simultaneously. Convergent applicator 12 can produce feature sizes with lateral dimensions on the order of 100 nanometers. Thickness of a layer (e.g., about 50 microns) can be variously applied and, large volumes of material can be printed in single pass. The printed mark would essentially become a 2D feature if the surface was to get wet. Applicator 12 can apply pastes to render three dimensional (3D) structures with relatively high aspect ratio, typically 2:1 or greater, for example, 10:1 for fuel cell applications.

Productivity of a co-extrusion process typically depends on dispense rate of fluids and for a fixed nozzle pressure, dispense rate is lower for fluids of higher viscosity. To achieve high process throughput, low viscosity is desired. On the other hand, to produce co-extruded composite material with well defined interfaces and overall shape that follows the nozzle geometry, high viscosity is desired. One way to achieve high nozzle throughput and shape retention is to dispense shear-thinning fluids. Such, non-Newtonian fluids, generally lower their viscosity in the presence of shear stress, sometimes by large amounts, even by factors of 100 in some cases for example as described in Rao et al., Adv. Materials vol. 17 no. 3 (2005).

FIGURE 2 illustrates a comparative example of an applicator that can be used as applicator 12 of device 10.

The applicator includes manifold 20 having a first side 22 and second side 24. Manifold 20 can be fabricated by known micro-machining techniques such as deep reactive ion etching and wafer bonding, for example. Each of halves 22 and 24 include M channels 26, wherein M is an integer equal to or greater than one (e.g., thousands or more). For clarity, ten channels are shown. Channels 26 typically are machined to extend a defined length of manifold 20, e.g., channels 26 may be fabricated to be relatively longer than an entrance length to create laminar flow, but less then the entire length of manifold 20. Channels 26 can also be machined to create similar and/or different shaped uniform and/or non-uniform channels.

Sides 22 and 24 are depicted as two independent structures; however, manifold 20 can be created as a single unit and/or more than two pieces (e.g., each of sides 22 and 24 may be formed from multiple components). When sides 22 and 24 are together, each of channels 26 forms one or more isolated compartments, conduits, passageways, etc. beginning at first end 28 of manifold 20 and extending toward second end 30 of manifold 20 up to region 32 where channels 26 terminate and converge into single volume 34. In other instances, compartments, conduits, passageways, etc. formed by channels 26 may not be isolated such that materials flowing through adjacent channels may come into contact with each other.

Manifold 20 further includes ports for receiving materials. As depicted, a plurality of ports 36 can be interleaved and located on first side 22, and a plurality of ports 38 can be interleaved and located on second side 24. In other instances, the ports 36 and 38 can all be located on one and/or both of sides 22 and 24 of manifold 20. A single material may be fed into ports 36 and 38 or a different material may be fed into each of ports 36 and 38. In yet another instance, one or more materials may be fed into ports 36 on first side 22 of manifold 20, and one or more different materials may be fed into ports 38 on second side 24 of manifold 20.

Different materials traverse through respective channels 26 and merge within region 34 of manifold 20 to form a single flow comprising multiple materials in which adjacent materials within the flow originate from adjacent channels and can be similar and/or different materials. Under laminar flow conditions, materials traversing through channels 26 and merging in region 34 typically do not mix or there is relatively minimal mixing of materials. Viscosities of materials can be matched to reduce shear and mixing between materials. Additionally, channels 26 may be shaped to counteract effects of surface tension on material as it progresses out of manifold 20.

Manifold 20 and/or M channels 26 can be variously shaped to facilitate producing laminar flow, merging different materials, and/or producing a desired shape on substrate 14. A suitable manifold shape includes a trapezoidal shape with channels extending and/or tapering from first end 28 of manifold 20 to second end 30 of the manifold.

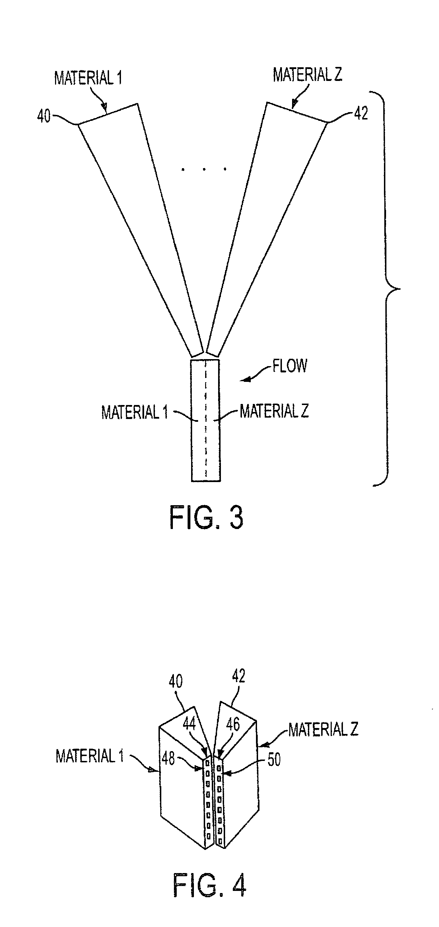

FIGURES 3 and 4 illustrate another comparative example of an applicator that can be used as applicator 12 of device 10, where separate structures are used to dispense each material. Dispenser 40 is used to apply a first material, and dispenser 42 is used to apply Zth material, wherein Z is an integer equal to or greater than one. Dispensers 40 and 42 can be positioned relative to each other by micro-positioners and/or other suitable drives. Alignment from channel-to-channel can also be achieved by interlocking features built into dispensers 40 and 42, such as comb-like structures. Since the materials come into contact outside of dispensers 40 and 42, materials can be partially intermixable if the materials can be cured relatively rapidly after being dispensed onto substrate 14 (e.g. UV-curing). Materials can be co-mingled into a layer in flight between channel tips and substrate 14. Alternately, separate stripes on substrate 14 may flow together once materials are deposited on substrate 14.

FIGURE 4 shows each of dispensers 40 and 42 can include one or more dispensing ports. Dispenser ports 44 are used to apply the first material, and dispenser ports 46 are used to apply Zth material. Ports 44 can be separated by a plurality of (equal or non-equal) gaps 48 for applying a plurality of flows of first material. Ports 44 can be offset parallel to ports 44 and separated by a plurality of (equal or non-equal) gaps 50 in order to facilitate dispensing Zth material in gaps 44 to render a flow comprising alternating materials with a width based on an aggregate number of ports 44 and 46.

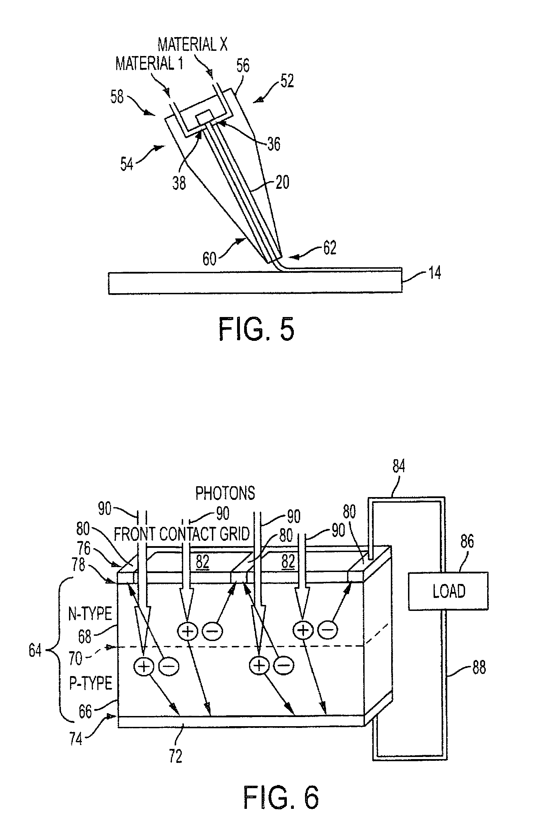

FIGURE 5 illustrates another comparative example of an applicator that can be used as applicator 12. The applicator is used to apply two different materials on substrate 14. The applicator includes manifold 20, which includes a plurality of channels 26 that are fabricated to facilitate creating laminar flow to merge materials received in each channel 26 within manifold 20 into a single flow of separate materials (with material to material contact) while mitigating mixing of the materials. Channels 26 are associated with either ports 36 or ports 38, which are used to introduce at least one of the materials into manifold 20. Two such ports are illustrated.

Typically, the two different materials are introduced into manifold 20 in an interleaved manner such that adjacent channels 26 are used for different materials. However, similar materials can be introduced into adjacent channels. As depicted, two different materials can be introduced into manifold 20 from opposing sides 52 and 54. In other configurations, two different materials can be introduced from a substantially similar side(s) (e.g., either side 52 or side 54), including introducing both materials from multiple sides (e.g., both side 52 and side 54). The side in which a material is introduced may be arbitrary or defined in order to establish a particular sequence.

A first material is supplied to some of channels 26 of manifold 20 through one or more of the plurality of ports 38, and another material is supplied to different channels 26 of manifold 20 through the plurality of ports 36. The relative position of ports 36 and 38 with respect to each other can be arbitrary such that manifold 20 could be turned 180 degrees. As described above, materials traverse (e.g., via a push, a pull, etc. technique) through corresponding channels and merge under laminar flow within manifold 20 to form a single flow of materials.

The applicator further includes housing 56, which reinforces the exterior of the applicator. Housing 56 can be designed to taper, or diminish in size (e.g., thickness, diameter, width, etc.) from back region 58 to front region 60. Such tapering provides relatively more support at back region 58, which typically includes the highest pressure regions of the applicator, while enabling dispensing end 62 to be positioned adjacent to and/or in contact with substrate 14. Such positioning can be based on factors such as distance between the applicator and substrate 14, the angle of dispensing end 62 with respect to substrate 14, etc.

The applicator and/or substrate 14 can be moved in order facilitate applying the materials to substrate 14. Relatively narrower dispensing end 62 enables multiple applicators to be arrayed together in a staggered or non-staggered arrangement to increase width of material applied with each pass of the applicators across substrate 14. Substrate 14 can be fed as cut sheets or in a roll-to-roll process. Flow speed of the material can be controlled as described above. For example, pressure of the materials can be suitably adjusted to effectuate flow speed.

FIGURE 6 illustrates a portion of a photovoltaic cell, such as a solar cell, with grid lines created via applicator 12. The photovoltaic cell includes semiconductor 64 with p-type region 66 and n-type region 68. One or both of regions 66 and 68 of semiconductor 64 can be formed from semiconductor materials such as, for example, Aluminium Arsenide, Aluminium Gallium Arsenide, Boron Nitride, Cadmium Sulfide, Cadmium Selenide, Diamond, Gallium Arsenide, Gallium Nitride, Germanium, Indium Phosphide, Silicon, Silicon Carbide, Silicon Germanium, Silicon on insulator, Zinc Sulfide, Zinc Selenide, etc. An electric field is created across p-n junction 70 and allows electrons and/or holes to flow from one region to another region of semiconductor 64, for example, upon absorption of a photon. Electrons pass from n-type region 68 into p-type region 66, and holes pass from p-type region 66 to n-type region 68.

The photovoltaic cell further includes contact 72 formed adjacent to side 74 of p-type region 66. Contact 72 can be formed via metal paste such as aluminum based paste. Grid contact 76 is formed adjacent to side 78 of n-type region 68. Grid contact 76 includes conducting fingers 80 separated by non-conducting regions 82. Fingers 80 can be formed via a metal paste such as silver based paste. Contacts 72 and/or 76 may be exposed to heat treatment, and/or drying, curing, and/or sintering, and/or other processes.

After contacts 72 and 76 are created, a plurality of the cells can be interconnected in series and/or parallel, for example, via flat wires or metal ribbons, and assembled into modules or panels. A sheet of tempered glass (not shown) may be layered over grid contact 76 and/or a polymer encapsulation (not shown) may be formed over contacts 72. The photon absorbing surface may include a textured surface and/or be coated with antireflection material (e.g., silicon nitride, titanium dioxide, etc.) in order to increase the amount of light absorbed into the cell. Grid contract 76 can be formed as rectangular bars or variously shaped, for example, as triangular volumes (e.g., with the point of the triangle facing away from the semiconductor 64) that facilitate directing photons into semiconductor 64 and mitigating blocking photons from entering semiconductor 64, which can improve efficiency and/or generation of electrical power.

Electrode 84 can be connected to grid contacts 76 and external load 86, and electrode 88 can be connected to external load 86 and contact 72. When photons 90 are absorbed into semiconductor 64, their energy excites electrons therein, which subsequently freely move. Electrical current is generated when excited electrons in n-type region 68 travel through grid contact 76 and electrode 84 to external load 86 and back through electrode 88 and contact 72 to p-type region 72.

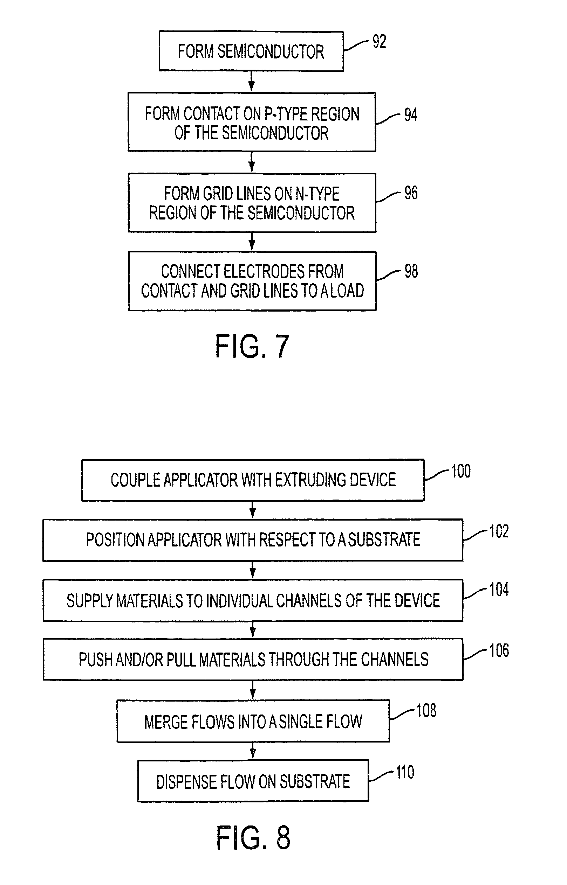

FIGURE 7 illustrates a method for fabricating grid lines on a photovoltaic device such as the photovoltaic cell described in connection with FIGURE 6. At 92, a semiconductor is formed, which can include various semiconductor materials. The semiconductor can be formed by coupling a piece of n-type silicon with a piece of p-type silicon to form a semiconductor p-n junction, or an n-type dopant (e.g., Phosphorus, Arsenic, Antimony, etc.) or a p-type dopant (e.g., Boron, etc.) is diffused into a side of a silicon wafer, or naturally occurring semiconductors such as blue diamonds, which contain Boron impurities, can be used. The photovoltaic cells can be coupled in a serial and/or parallel manner to create a photovoltaic module or panel. At 94, a conducting contact is formed adjacent to the p-type region. At 96, a conducting grid is formed adjacent to the n-type region. In one example, device 10, as described above, is used to form the conducting grid. At 98, electrodes are coupled from the conducting contact and the conducting grid to a load. When photons are absorbed into the semiconductor, electrical energy is generated via the photovoltaic effect.

FIGURE 8 illustrates a method for fabricating grid lines in connection with FIGURE 6. At 100, one or more applicators (e.g., applicators 12) can be coupled to an extruding device (e.g., device 10). The applicators can be coupled in a serial (e.g., staggered or non-staggered) and/or parallel manner. At 102, the device can be suitably positioned with respect to a surface of the photovoltaic substrate.

At 104, silver paste and sacrificial material are fed into applicators. The silver paste and sacrificial materials can be pushed and/or drawn into the applicators through known techniques. Each of the applicators can include a plurality of channels fabricated to facilitate producing laminar flow for merging materials within the applicators while mitigating mixing of such materials. Silver paste and sacrificial material typically are fed in an interleaved manner such that adjacent channels are fed different materials (e.g., one channel is fed silver paste while an adjacent channel is fed the sacrificial material), or alternating channels are fed a similar material (e.g., every odd channel or every even channel is fed is either silver paste or sacrificial material).

At 106, materials traverse through their respective channels. Parameters such as rate, temperature, duty cycle, etc. are set based at least in part on factors such as material viscosity and/or desired characteristics such as grid line length, width, strength, resistance, etc. These parameters are set to produce a laminar flow for each material traveling through each of the channels. At 108, a plurality of flows from the plurality of channels within each applicator is merged into a single flow of alternating materials. Since each flow is a laminar flow, the materials merge with reduced mixing relative to non-laminar flows. The sacrificial material is preferably, but is not limited to, a material with a closely matched rheology to that of the silver paste.

At 110, merged materials are dispensed from each of the applicators and applied to the photovoltaic substrate to create grid lines. The device and applicators and/or photovoltaic substrate can be moved relative to the other, and can be used multiple times in order to create a desired width and/or apply a desired number of layers, for example, for introducing barrier layers onto the photovoltaic substrate like a metal bi-layer with one metal making contact with the substrate as a diffusion barrier and another metal formed over it to reduce cost and/or increase conductance. Grid lines can be further processed, for example, via heat treatment or sintering to make Ohmic contact with the substrate.

Using applicator 12 for the grid lines results in grid lines with a high aspect ratio such as up to about 10:1 and relatively fine features such as less than about 5 to 10 microns. With conventional systems, grid lines cover about 4% of the area and are opaque and metallic and, thus, block photons from entering semiconductor 64. The high aspect ratio fine feature grid lines produced via applicator 12 take up less than 4% of the area and allow more photons to enter semiconductor 64, which improves electrical power output. Because narrow grid lines have a smaller metal-to-semiconductor contact area, a beneficial effect of reducing electron-hole recombination is obtained.

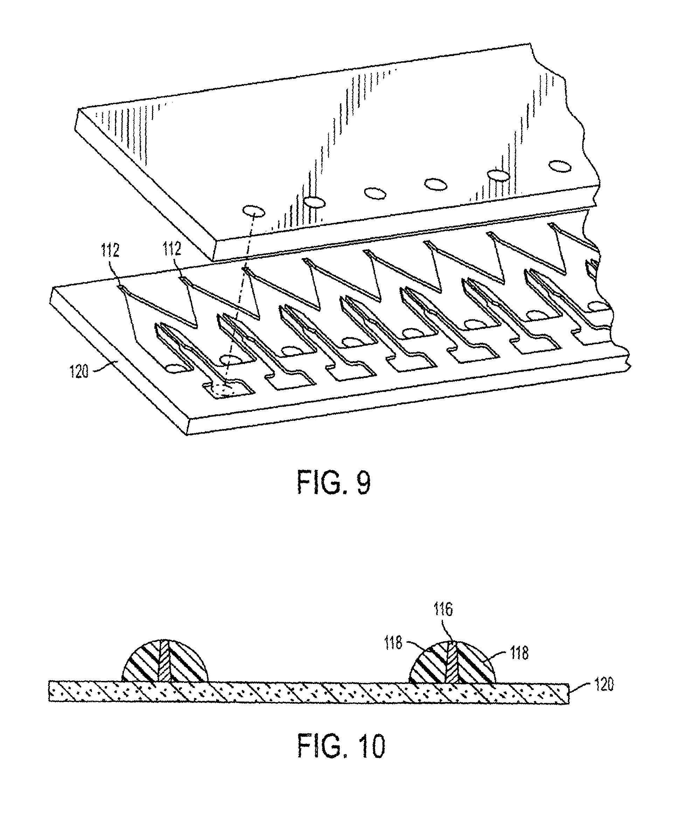

FIGURE 9 illustrates an exploded view of a portion of a co-extrusion/dispense applicator suitable for the deposition of solar cell gridlines. The applicator includes an array of outlets 112. Each of outlets 112 corresponds to a single gridline and dispenses a material composite consisting of a central metal line of high aspect ratio with supporting material adjacent to one or more sides of the metal line. FIGURE 10 depicts a cross section of two such gridlines dispensed via the applicator of FIGURE 9 on substrate 120. Each of the dispensed gridlines includes metal line 116 and support material 118. Returning to FIGURE 9, convergent path 120 leading to each outlet 112 has advantages in comparison to a straight channel. The extruded features can be finer than the finest minimum design feature of the applicator itself. The applicator uses less material to support the gridline compared to one that uses a single outlet.

A co-extrusion applicator with the estimated parameters illustrated in Table 1 could be used to dispense materials to make gridlines on a crystalline silicon solar cell.

Table 1. Exemplary applicator parameters for generating a gridline.

| Sheet Thickness | 152 microns |
|---|---|
| Gridline Pitch | 2.5 mm |
| Applicator Speed | 1 cm/sec |
| Past Viscosity | 100,000 Cp |
| Applicator Angle | 45 degrees |
| Applicator Exit Width | 304.8 Microns |
| Silver Width | 49.2 microns |
| Silver Line Cross Section | 7,500 microns^2 |
| Silver Line Aspect Ratio | 3.10:1 |
| Silver Flow | 0.075 mm^3/sec |
| Applicator Compression | 6.2:1 |
| Applicator Pressure Drop | 2.27 bar (2.24 atm) |

With this design, convergent channels are patterned into a sheet of material with a thickness of approximately 0.15 mm. Output orifices of the applicator/nozzles are repeated on a pitch of 2.5 mm. At an applicator/nozzle pressure of approximately 2.27 bar (2.24 atm), paste of 1000 poise is ejected at a rate of 1 cm/sec. The central stripe of silver is approximately 50 microns wide with an aspect ratio of 3.1.

An applicator/nozzle with many separate outputs may have inherent instability, particularly fluid being dispensed undergoes large amounts of shear thinning. This instability could cause fluids in different channels to divide into different flow states. The flows could divide into low flow, low shear, high viscosity state in some channels while others have a high flow, high shear, low viscosity state. An undesirable condition is one in which given fluid displacement rate, overall pressure drop is lowest for a combination of high and low output flows. One way to avoid uneven flows from a dispense nozzle with multiple outputs (such as the applicator of FIGURE 9) is to drive each output from a separate fluid pump. A particularly desirable and cost effective way to achieve this is to create an array of positive displacement pumps in which fluid in multiple reservoirs is simultaneously compressed by a single actuator, such as a motor and lead screw driving a plate with multiple plungers.

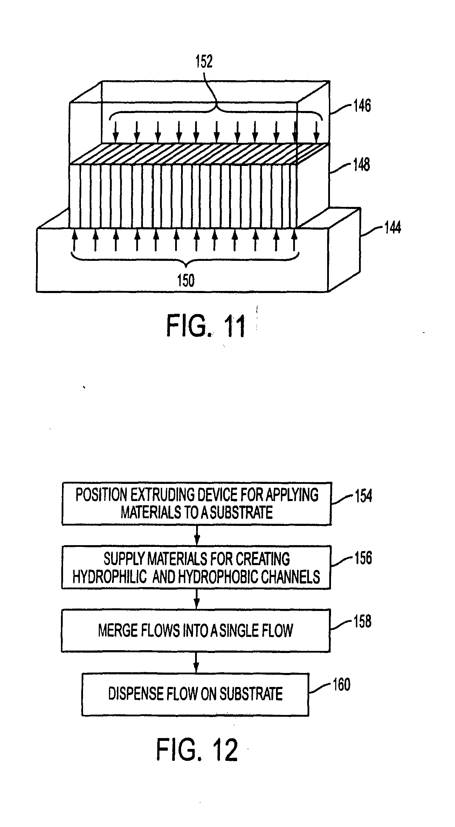

FIGURE 11 illustrates an exemplary fuel cell anode with at least one channel created via applicator of FIGURE 9. The applicator of FIGURE 9 can be used to create barrier channels and/or electrodes for other electrochemical devices such a batteries (e.g., zinc-air), etc.

The fuel cell anode includes a porous electrode and gas diffusion layer 144, membrane 146 consisting of for example phosphoric acid bound in a polymer structure, and composite porous electrode 148 disposed there between. Electrode 144 typically is a porous electrode and gas diffusion layer which allows reactants, such as oxygen for a hydrogen fuel cell, to permeate into composite porous electrode 148, consisting of alternating vertical stripes of nanoporous hydrophobic material (e.g., polytetrafluoroethylene particles) 150 and nanoporous phdrophilic conductor and catalyst 152 (e.g., graphite particles and platinum). A catalyst, such as platinum, in conductor lines 152 catalyzes the reaction to produce water. In once instance, the reaction is characterized by the following: $H^+ + \frac{1}{2}O_2 + e^- \xrightarrow{P_t} H_2O$.

The porous nature of the stripes 150 and 152 provide for continuous replenishment of the reactants consumed within the composite porous electrode 148.

Relatively high aspect ratio (10:1) thin feature (5-10 microns) porous lines are desirable because they produce a long reaction zone that increases utilization of the expensive catalyst needed for the electrode. However, conventional extrusion techniques cannot fabricate such lines on relatively rough (0.01 mm RMS) substrates at costs below $1/square foot. In addition, the structure should facilitate conducting protons form the membrane to the reaction site, diffusing oxygen to the reaction site with low partial pressure drop, conducting electrons from the porous electrode to the reaction site, carry heat away from the reaction site, and withstand a compressive mechanical load of 6.89 - 13.79 bar (100-200 PSI). The challenges imposed by the electrode structure and its target cost place nearly impossible demands on conventional photolithographic, direct marking, and molding techniques. To compensate for this deficiency, conventional techniques commonly use more catalyst than desired to increase the number of reaction sites and/or employ agglomerates of carbon catalyzed with Platinum in a matrix of a porous material, or polytetrafluoroethylene (PTFE). The applicator of FIGURE 9 can be used to produce high aspect-ratio (10:1) thin conductor lines 150 interleaved with porous PTFE 152 (5 microns or less) on relatively rough (0.01 mm RMS) substrates at costs below $1/square foot.

FIGURE 17 illustrates a method for fabricating the membrane electrode assembly of the fuel cell described in FIGURE 16. At 154, suitably position a device employing the applicator of FIGURE 9 with respect to a surface of a substrate. Such positioning includes a distance between dispensing ends of the applicators and the photovoltaic device, an angle of the dispensing ends of the applicators with respect to the photovoltaic substrate, etc.

At 156, a first material for creating hydrophilic lines, and a second material for creating hydrophobic lines are fed into the applicator(s). Each of the applicators can include a plurality of channels fabricated to facilitate producing laminar flow for merging materials within the applicators while mitigating mixing of such materials. The first and second materials typically are fed in an interleaved manner such that adjacent channels are fed different materials, or alternating channels are fed a similar material. Parameters such as rate, temperature, duty cycle, etc. are set based at least in part on factors such as material viscosity and/or desired characteristics such as grid line length, width, strength, resistance, etc. These parameters are set to produce a laminar flow for each material traveling through each of the channels.

At 158, a plurality of flows from a plurality of channels within each applicator is merged into a single flow of alternating materials. Since each flow is a laminar flow, the materials merge with reduced mixing relative to non-laminar flow flows. At 160, the merged materials are dispensed from the applicator(s) to create a plurality of channels the form the electrolyte. The applicator(s) and/or substrate can be moved relative to the other. The applicator(s) can be used multiple times in order to create a desired width and/or apply a desired number of layers.

To reduce the mixing of pastes and particles that the materials include, the materials can be formulated such that they are substantially immiscible. Particles that form the network of porous media in the electrode can be coated, if necessary, with hydrophilic or hydrophobic coatings to affect their intermixing. Both pairs and combinations of liquids and colloidal suspensions can be made to be mutually insoluble, enabling striped layers of these materials to be extruded onto the substrate through the applicator without substantial mixing.

Table 2 provides examples of throughput related parameters for the applicators described herein. The throughput related parameters were obtained by estimating a pressure gradient to produce a Poiseuille flow in a rectangular cross section at various points along a length of applicator 12.

Table 2. Throughput related parameters for the applicators described herein.

| | |
|---|---|
| Ejector Convergence | 10 to 1 |
| Injector Pitch | 50 microns |
| Injector Size | 25 microns |
| Array Width | 1000 injectors |
| Number of applicators | 10 nozzles |
| Applicator Height | 200 microns |
| Page Print Time | 1 minutes |
| Page size | 300 mm |
| Layer Thickness | 50 microns |
| Exit Pitch | 5 microns |
| Array width | 50 mm at input |
| Applicator width | 5 mm at output |
| Applicator speed | 30 mm/sec |
| Applicator flow speed | 7.5 mm/sec |
| Applicator flow rate | 7.5 $mm^3$/sec |

(continued)

| Viscosity | 5000 cP or 5 kg/m.sec |
|---|---|
| Flow Rate | 7.5 mm$^3$/sec or 7.5E-09 m$^3$/sec |
| Applicator length | 50 mm |
| Pressure Drop | 1.66 bar (24 PSI) |

From Table 2, for a modest number of applicators, for example, about 10, and a pressure of about 1.66 bar (24 PSI), a relatively highly viscous material could be printed at a rate of about 1 square foot per minute. Injector pitch at the wide end of the applicator is about 50 microns, and width converges from about 50 mm to about 5 mm, with about 1000 injection ports, and a printed pitch at the applicator opening of about 5 microns. Height of the layer deposited by the applicator is about 50 microns, whereas the applicator channel is about 200 microns deep. The deposited layer is thinned by stretching, or moving the substrate faster (e.g., about four-times) than flow rate of materials as they leave the applicator. Depending on properties of materials, it may be possible to stretch a bead by relatively large ratios. If applicator channel is about 500 microns deep, and layer thickness is about 50 microns, a substantially similar print speed can be achieved with a pressure drop of only about 117 mbar (1.7 PSI). For finer pitch, the applicator can include more injection ports or a narrower opening.

## Claims

1.  A device for extruding/dispensing materials on a substrate, the device including an applicator comprising:

    a housing;
    at least three channels enclosed by the housing, the at least three channels facilitating flow of materials;
    at least one entrance port associated with each of the channels for feeding a material into each channel; and
    an exit port (112) for co-extruding/dispensing the materials **characterized in that** the at least three channels are arranged to define:

    a central channel extending between a first end and a second end, the first end of the central channel communicating with the corresponding entrance port of said channel, and
    first and second side channels disposed on laterally opposite sides of the central channel, each of the first and second side channels extending between an associated first end and an associated second end, wherein the first ends of the first and second side channels respectively communicate with corresponding entrance ports of said channels, and **in that** the housing further comprises:

    a single volume region communicating with the second ends of each of the central channel and the first and second side channels, the single volume region also communicating with the exit port (112), wherein the first and second side channels and the central channel converge at the single volume region such that when a first material is introduced into the central channel through the first inlet port and a second material is introduced into the first and second side channels through the second and third inlet ports, the first material and second material form a single flow in the single volume region in which the first material is sandwiched laterally between portions of the second material, the structure of the device being such that as the first and second materials are co-extruded onto a substrate, the first and second materials will form parallel elongated gridline structures on the surface of the substrate, each said gridline structure including a central line structure formed by said first material that contacts the surface of the substrate, and support structures formed by the second material that contacts opposing side surfaces of the central line structure, wherein the central channel is formed such that said central line structure of said gridline structure will have an aspect ratio greater than 2:1, and wherein the central channel has a width not greater than 100 microns.

2.  The device of claim 1, wherein the central channel is formed such that said central line structure of said gridline structure will have a width in the range of 100 nanometers to 100 microns.

3.  The device as set forth in any of the preceding claims, wherein the housing has one or more of a trapezoidal shape in a two-dimensional layout and a trapezoidal cross-section in a three-dimensional layout and the at least three channels are formed to merge the materials flowing through each of the channels in the single volume region associated with a narrower end of the housing.

4. The device as set forth in any of the preceding claims, further including multiple applicators aligned with respect to each other in one of an array, a stack, and a matrix configuration.

5. The device as set forth in any of the preceding claims, wherein the housing is substantially a planar fabricated structure.

6. The device as set forth in any of the preceding claims, further including an agitator that provides agitation to a lower viscosity of at least one of the materials.

7. The device as set forth in any of the preceding claims, further including one or more components, such as positive displacement pumps, that pump the materials through the housing.

**Patentansprüche**

1. Eine Vorrichtung zur Extrusion/Dosierung von Materialien auf ein Trägermaterial, wobei zur Vorrichtung ein Applikationsgerät gehört, das aus folgenden besteht:

   einem Gehäuse;
   zumindest drei, im Gehäuse umschlossenen Rinnen, wobei die zumindest drei Rinnen den Durchfluss von Materialien ermöglichen;
   zumindest einer Einlassöffnung für jede der Rinnen, um jeder Rinne Material zuzuführen; und
   einer Auslassöffnung (112) zur Koextrusion/Dosierung der Materialien, **dadurch gekennzeichnet, dass** die zumindest drei Rinnen so angeordnet sind, dass Folgendes gebildet wird:

   eine mittlere Rinne zwischen einem ersten Ende und einem zweiten Ende, wobei das erste Ende der mittleren Rinne mit der entsprechenden Einlassöffnung der genannten Rinne in Verbindung steht, und ersten und zweiten Nebenrinnen, die an lateral gegenüberliegenden Seiten der mittleren Rinne angeordnet sind, wobei jede der ersten und zweiten Nebenrinnen zwischen dazugehörigen ersten Enden und dazugehörigen zweiten Enden verläuft, wobei die ersten Enden der ersten und zweiten Nebenrinne jeweils mit den entsprechenden Einlassöffnungen der genannten Rinnen in Verbindung stehen, wobei das Gehäuse zudem Folgendes aufweist:

   einen einheitlichen Volumenbereich in Verbindung mit den zweiten Enden jeweils der mittleren Rinne und der ersten und zweiten Seitenrinne, wobei der einheitliche Volumenbereich zudem mit der Auslassöffnung in Verbindung (112) steht, wobei die erste und zweite Nebenrinne und die mittlere Rinne im einheitlichen Volumenbereich zusammenlaufen, so dass, wenn ein erstes Material durch die erste Einlassöffnung in die mittlere Rinne eingeführt wird und ein zweites Material durch zweite und dritte Einlassöffnung in die erste und zweite Nebenrille eingeführt wird, das erste Material und das zweite Material im einheitlichen Volumenbereich einen einzelnen Durchfluss bilden, wobei das erste Material lateral zwischen Teilen des zweiten Materials eingepresst wird, wobei die Struktur der Vorrichtung so angelegt ist, dass das erste und zweite Material auf ein Trägermaterial koextrudiert werden und das erste und das zweite Material parallele, längliche Rasterlinienstrukturen auf der Oberfläche des Trägermaterials bilden, wobei jede Rasterlinienstruktur aus einer mittleren Linienstruktur, die das genannte erste Material gebildet wird, welches mit der Oberfläche des Trägermaterials in Kontakt kommt, und Stützstrukturen, die durch das zweite Materialbeim Kontakt mit gegenüberliegenden Seitenfläche der mittleren Linienstruktur gebildet werden, besteht;
   wobei die mittlere Rinne so gebildet wird, dass die genannte mittlere Linienstruktur der genannten Rasterlinienstruktur ein Aspektverhältnis von mehr als 2:1 aufweist und wobei die zentrale Rinne eine Breite von nicht mehr als 100 Mikron aufweist.

2. Die Vorrichtung entsprechend Anspruch 1, wobei die mittlere Rinne so gebildet ist, dass die genannte mittlere Linienstruktur der genannten Rasterlinienstruktur eine Breite im Bereich von 100 Nanometern bis 100 Mikron aufweist.

**3.** Die Vorrichtung entsprechend einem der vorangegangenen Ansprüche, wobei das Gehäuse in einem zweidimensionalen Layout ein oder mehr trapezförmige Formen und in einem dreidimensionalen Layout einen trapezförmigen Querschnitt aufweist und die zumindest drei Rinnen so gebildet sind, dass sie das Material, das durch jede der drei Rinnen fließt im einheitliche Volumenbereich, der mit dem schmaleren Ende des Gehäuse assoziiert ist, vereinen.

**4.** Die Vorrichtung entsprechend einem der vorangegangenen Ansprüche, zu der weiterhin mehrere Applikatoren gehören, die zueinander in einer Reihe, einem Stapel und eine Matrixkonfiguration ausgerichtet sind.

**5.** Die Vorrichtung entsprechend einem der vorangegangenen Ansprüche, wobei das Gehäuse im Wesentlichen eine flache Struktur ist.

**6.** Die Vorrichtung entsprechend einem der vorangegangenen Ansprüche, zudem weiterhin ein Rührer gehört, der durch Rühren für zumindest eines der Materialien eine niedrigere Viskosität erzeugt.

**7.** Die Vorrichtung entsprechend einem der vorangegangenen Ansprüche, zu der weiterhin eine oder mehrere Komponenten gehören, wie z.B. Druckpumpen, die das Material durch das Gehäuse pumpen.


**Revendications**

**1.** Moule d'extrusion/de distribution de matériaux sur un substrat, le moule étant muni d'un applicateur comprenant :

un boîtier ;
au moins trois canaux enveloppés par le boîtier, les au moins trois canaux facilitant le flux de matériaux;
au moins un orifice d'entrée associé à chacun des canaux en vue d'alimenter un matériau à chaque canal ; et
un orifice de sortie (112) pour la coextrusion/la distribution des matériaux **caractérisé en ce qu'**au moins trois canaux sont agencés pour définir :

un canal central s'étendant entre une première extrémité et une deuxième extrémité, la première extrémité du canal central communiquant avec l'orifice d'entrée correspondant dudit canal, et
un premier et un deuxième canal latéral disposés sur les côtés latéralement opposés du canal central, chacun des premier et deuxième canaux latéraux s'étendant entre une première extrémité associée et une deuxième extrémité associée, dans lequel les premières extrémités des premier et deuxième canaux latéraux communiquent respectivement avec les orifices d'entrée correspondants desdits canaux et **en ce que** le boîtier comprend en outre ;
une région de volume unique communiquant avec les deuxièmes extrémités de chacun du canal central et des premier et deuxième canaux latéraux, la région de volume unique communiquant également avec l'orifice de sortie (112), dans lequel les premier et deuxième canaux latéraux et le canal central convergent au niveau de la région de volume unique de façon telle que, lorsqu'un premier matériau est introduit dans le canal central par le premier orifice d'entrée et un deuxième matériau est introduit dans les premier et deuxième canaux latéraux par le deuxième et troisième orifice d'entrée, les premier et deuxième matériaux forment un flux unique dans la région à volume unique dans laquelle le premier matériau est pris en sandwich latéralement entre les parties du deuxième matériau, la structure du dispositif étant telle qu'à mesure que le premier et le deuxième matériau sont co-extrudés sur un substrat, les premier et deuxième matériaux formeront des structures de lignes de grille allongée parallèles sur la surface du substrat, chacune de ladite structure de ligne de grille comprenant une structure de ligne centrale formée par ledit premier matériau qui entre en contact avec la surface du substrat et qui supporte les structures formées par le deuxième matériau qui entre en contact avec les surfaces latérales opposées de la structure de ligne centrale, dans lequel le canal est formé de telle façon que ladite structure de ligne centrale de ladite structure de ligne de grille aura un rapport de forme supérieur à 2:1 et dans lequel le canal central a une largeur non supérieure à 100 microns.

**2.** Moule selon la revendication 1, dans lequel le canal central est formé de manière à ce que ladite structure de ligne centrale de ladite structure de ligne aura une largeur se situant dans la plage de 100 nanomètres à 100 microns.

**3.** Moule tel que présenté dans l'une quelconque des revendications précédentes, dans lequel le boîtier a une ou plusieurs d'une forme trapézoïdale en un agencement bidimensionnel et une coupe trapézoïdale en un agencement tri-dimentionnel et au moins trois canaux sont formés pour mélanger les matériaux s'écoulant de l'un de chacun des canaux dans la région de volume unique associée à l'extrémité plus étroite du boîtier.

4. Moule selon l'une quelconque des revendications précédentes, comprenant en outre des applicateurs multiples alignés l'un par rapport à l'autre dans une configuration de série.

5. Moule selon l'une quelconque des revendication précédentes, dans lequel le boîtier est sensiblement une structure planaire fabriquée.

6. Moule selon l'une quelconque des revendications précédentes comprenant en outre un agitateur qui procure une agitation à une viscosité plus basse qu'au moins l'un des matériaux.

7. Moule selon l'une quelconque des revendications précédentes, comprenant en outre un ou plusieurs composants, tels que des pompes de déplacement positif qui pompent les matériaux à travers du boîtier.

EP 1 787 785 B1

FIG. 1

FIG. 2

MATERIAL 1                                    MATERIAL Z

40                                                    42

. . .

FLOW

MATERIAL 1        MATERIAL Z

## FIG. 3

40        42

44        46        MATERIAL Z

MATERIAL 1    48        50

## FIG. 4

MATERIAL X
MATERIAL 1

MATERIAL 1 56
58 52
54 36
38 20
60 62
14

## FIG. 5

84

PHOTONS

90 90 90 80 90
80 FRONT CONTACT GRID 80
76 82 82
78
N-TYPE LOAD 86
64 68 (+) (−) (+) (−)
70
P-TYPE (+) (−) (+) (−) 88
66
74
72

## FIG. 6

FORM SEMICONDUCTOR — 92

FORM CONTACT ON P-TYPE REGION
OF THE SEMICONDUCTOR — 94

FORM GRID LINES ON N-TYPE
REGION OF THE SEMICONDUCTOR — 96

CONNECT ELECTRODES FROM
CONTACT AND GRID LINES TO A LOAD — 98

## FIG. 7

COUPLE APPLICATOR WITH EXTRUDING DEVICE — 100

POSITION APPLICATOR WITH RESPECT TO A SUBSTRATE — 102

SUPPLY MATERIALS TO INDIVIDUAL CHANNELS OF THE DEVICE — 104

PUSH AND/OR PULL MATERIALS THROUGH THE CHANNELS — 106

MERGE FLOWS INTO A SINGLE FLOW — 108

DISPENSE FLOW ON SUBSTRATE — 110

## FIG. 8

FIG. 9

FIG. 10

152

146

148

144

150

**FIG. 11**

| | |
|---|---|
| POSITION EXTRUDING DEVICE FOR APPLYING MATERIALS TO A SUBSTRATE | 154 |
| SUPPLY MATERIALS FOR CREATING HYDROPHILIC AND HYDROPHOBIC CHANNELS | 156 |
| MERGE FLOWS INTO A SINGLE FLOW | 158 |
| DISPENSE FLOW ON SUBSTRATE | 160 |

**FIG. 12**

FIG. 13

FIG. 14

FIG. 15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0050215 A
- JP 200505126 A
- WO 9115355 A
- US 20030201581 A

### Non-patent literature cited in the description

- **Rao et al.** *Adv. Materials,* 2005, vol. 17 (3